Europäisches Patentamt

(19) European Patent Office

Office européen des brevets

(11) Publication number: **0 270 149 B1**

(12) **EUROPEAN PATENT SPECIFICATION**

(45) Date of publication of patent specification :
05.06.91 Bulletin 91/23

(51) Int. Cl.⁵ : **G11C 7/00**

(21) Application number : 87202068.0

(22) Date of filing : 27.10.87

(54) **A semiconductor memory with storage locations wherein data can be stored through optical signals.**

(30) Priority : 27.10.86 NL 8602684

(43) Date of publication of application :
08.06.88 Bulletin 88/23

(45) Publication of the grant of the patent :
05.06.91 Bulletin 91/23

(84) Designated Contracting States :
DE FR GB IT

(56) References cited :
EP-A- 0 152 689
US-A- 3 412 255
US-A- 3 631 411
US-A- 3 958 229

(73) Proprietor : 5th Generation B.V.
Noordeindseweg 61
NL-2651 LE Berkel en Rodenrijs (NL)

(72) Inventor : Dekker, L.
Noordeindseweg 61
NL-2651 LE Berkel en Rodenrijs (NL)
Inventor : Frietman, Edward E. E.
Ieplaan 65
NL-2565 LG The Hague (NL)

(74) Representative : Smulders, Theodorus A.H.J.,
Ir. et al
Vereenigde Octrooibureaux Nieuwe Parklaan
107
NL-2587 BP 's-Gravenhage (NL)

## Description

This invention relates to a semiconductor memory system comprising a matrix of electronic basic cells arranged in rows and columns, each of said cells defining a storage location, and at which cells logic data can be stored bitwise, which data can be read out from the storage locations by means of electric addressing signals.

Classical digital computers process data sequentially, i.e., only a single instruction can be executed in the central processing unit at a time. It will be clear that this constitutes a major restriction on increasing data processing speed. The reason that hitherto only sequential data processing has been used resides mainly in the cost prices of the hardware.

For some time now, parallel data processors have been known, which are capable of executing the same series of instructions on different data streams. Such parallel data processors have the advantage of being able to perform operations considerably faster, because a number of sub-operations are executed simultaneously. In the case of a parallel processor executing the same series of instructions on different data streams (Single Instruction Stream, Multiple Data Stream : SIMD), only one control unit is required, since the tasks executed in parallel have an identical architecture. This also limits the usability of these SIMD processors to specific applications.

Efforts have also been made to construct parallel data processors capable of executing different series of instructions of different data streams (Multiple Instruction Stream, Multiple Data Stream : MIMD). In such an MIMD processor, wherein different series of instructions are executed on different data streams, each processor module has its own control unit.

Each processor module usually is a classical digital computer, which, however, restricts the application possibilities. For a number of reasons, it is better to use as the processor module, instead of a digital computer, a type of processor module that is capable of parallel data processing itself. This means, for one thing, that the parallel data processing capacity can be distributed uniformly over all subsystems of a parallel data processor. A processor module of such a parallel data processor comprises a plurality of time-parallel operating processor elements.

It strongly depends on the details of the architecture of such a processor whether this can have a broad field of application or not. In practice, the efficiency of a parallel data processor may decrease considerably, due to several causes, even if the data processing step shows a substantial degree of parallelism. One reason is that often both the capacity and the simplicity of architecture of the links between the data processing subsystems, the processor elements, are insufficient. It is normal that, during some or all processing cycles, a data processing task requires using one or more of the previous results as input data. Consequently, a good interconnection structure is needed between all subsystems to avoid congestion during the exchange, storage and retrieval of data. In this respect, it is basically unallowable that a parallel data processor contains components that can be simultaneously accessed by a number of other component during a parallel run. For instance, the exchange of data cannot be realized satisfactorily by means of only one common data bus. A data processing subsystem knows from its parallel program, stored in its memory, at each point of time which variables it needs. An adequate conceptual approach to the problem of complete interconnection by means of the exchange of data from each processor element to any other processor element is the "broadcasting" principle, on account of which therefore each processor element gets available at its input the data produced by this very element, as well as the data produced by all other parallel processor elements. However, as a result of this, a large number of parallel data buses have to be realized in the construction of a parallel data processor.

One consequence of using the "broadcasting" principle is that each bit of each digital word representing an input variable should be available in each processor element before the point of time at which the processing cycle starts and that, consequently, a data bus should consist of as many electrical connections or wires as the total number of bits of all digital words.

The production and assembly of such a data link structure in the conventional manner, in which a great many copper wire connections will have to be realized, is highly labour-intensive and expensive and, moreover, leads to a practically unacceptably voluminous cable tree. Hitherto, indeed, designs have had to be limited to a small number of parallel data processing elements. Increasing the computing capacity of the parallel processor by increasing the number of parallel processor elements leads to a decrease in communication capacity, since the data link structure is necessarily reduced in volume.

This problem in the realization of complete interconnection can be solved elegantly for much larger computing capacities by using optical signals in the parallel data processor, instead of electrical signals, which optical signals are exchanged via optical fiber data buses between the various processor elements. The use of optical fibers has the advantage, in addition to a much smaller volume, that the known problems inherent in electric cabling, such as crosstalk, limited bandwidth, non-adjusted impedances and differences in propagation times, cannot occur and that the enormously labour-intensive assembly of the cabling is avoided.

Each processor element comprises an input buffer memory and an output buffer memory. At the input of the input buffer memory of each processor element, the optical signals entering via the data bus are converted e.g. by means of a photodetector into a series of electrical signals, while the electrical signals from the output buffer can be converted into optical signals by means of e.g. one LED per bit. The input buffer memory of a processor element is designed for storing the output data of the output buffer memories of all other processor elements in order that, if required for a computing run, these can be read by the associated processor element.

It is an object of the present invention to provide a memory, such as an input buffer memory for a processor element of a parallel data processor, in which the optical data signals, prior to being written into the memory, need not be converted first into electrical data signals and to that effect, the invention provides a semiconductor memory of the above described type, in which each basic cell includes at least one photodetection means, the light-sensitive surfaces of the photodetection means of the basic cells being essentially co-planar, there being provided means for positioning the end faces of a bundle of optical fibers relatively to the matrix of basic cells, while the photodetection means of at least some basic cells can each be exposed separately to separate optical fibers for producing a photodetection signal, each basic cell comprising an electronic circuit coupled to the photodetection means, said circuit, being adapted to read said photodetection signal under the control of a clock signal, and, depending on the signal read, to assume a logic state which persists until a new photodetection signal is read under the control of the clock signal.

The memory system according to the present invention has the substantial advantage that all memory locations can be addressed simultaneously in parallel fashion from a bundle of optical fibers, so that all data can be read simultaneously into the memory, with the end face of each fiber being basically aligned relatively to the photodetector of a basic cell. As a result, the writing-in of data into a memory, in particular a memory having a plurality of memory locations, can take place much more quickly than in a classical random access memory, wherein data signals to be stored in the memory are represented by electrical signals. Besides, it is also possible to integrate in a substrate containing at least some of the basic cells, an electronic data processing circuit for each basic cell, so that each basic cell, in addition to memory capacity, also has a certain processor capacity.

It is observed that a system wherein digital optical data is supplied to photodetectors is known from European patent 0006960. In this system, however, the photodetectors are not directly provided in the layer receiving data in the form of light pulses, but adjacent to this layer, whereas the data of the photodetectors is to be first processed further by electronic circuitry before it can be stored in a memory. US-A-3.631.411 discloses a semiconductor page memory having an array of memory units each of which includes an electrically accessible flip-flop for storing a binary information bit. Each flip-flop is provided with a photodiode by which the flip-flop can be set in response to received light, and is provided with a liquid crystal light valve controlled by the electrical state of the flip-flop. The page memory is used as a page-at-a-time electrical input-output unit for a great many pages of information stored optically on an erasable holographic storage medium.

One embodiment of the present invention will now be described, by way of example, with reference to the accompanying drawings, in which :

Fig. 1 is a diagrammatic representation of a data link structure with optical fibers for a parallel data processor ;

Fig. 2 shows an embodiment of a positioning element for linking a bundle of optical fibers to a memory according to the present invention ;

Fig. 3 shows a 4 × 4 matrix arrangement of basic cells in a memory according to the present invention ;

Fig. 4 diagrammatically shows the architecture of a single basic cell ; and

Fig. 5 shows a possible electronic circuitry for the basic cell shown in Fig. 4.

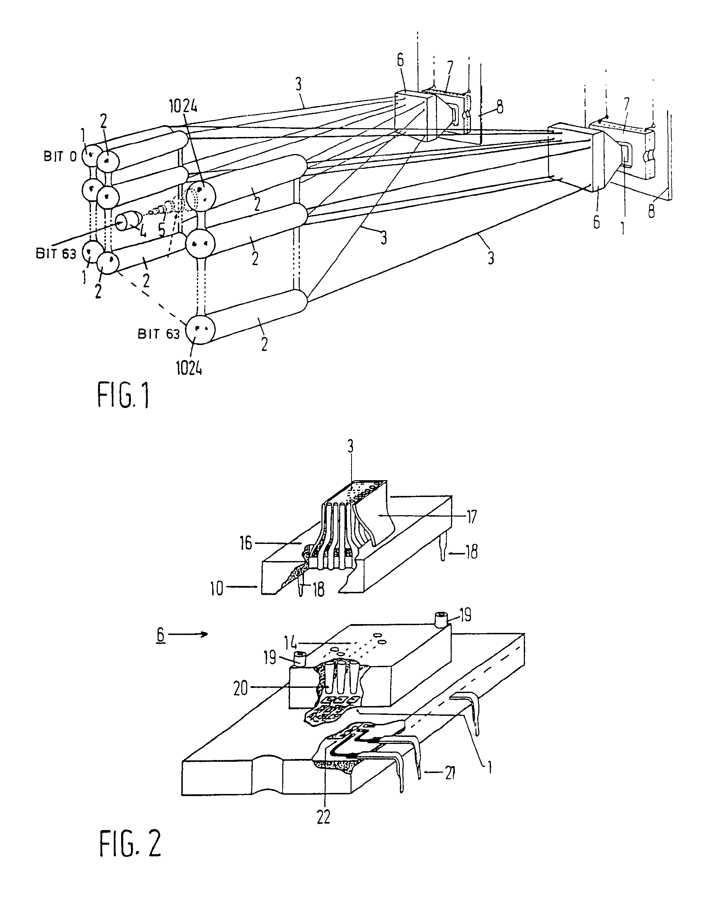

Fig. 1 shows a diagrammatic arrangement of the data communication system for a parallel data processor, in which, by way of illustration, only the addressing of two input buffer memories 1 for two processor elements is shown ; however, the structure shown is designed for addressing 1024 processor elements, each having a memory of 64 × 1024 bits. In the arrangement shown in Fig. 1, 64 × 1024 optical fiber bundles 2 are present, each of said bundles 2 consisting of 1024 optical fibers 3. Per fiber bundle 2 there is provided one LED 4, the figure showing only one, which shines on all fibers 3 of one bundle of optical fibers. Of one bundle 2, always one fiber 3 is connected to one of the 1024 buffer memories 1, so that via bundle 2 the LED 4 can light one memory location in each of the 1024 buffer memories. The position of the memory locations in each buffer memory 1 addressed by the fibers of one specific bundle is preferably always the same. Each LED 4 radiates light into bundle 2 via an optical system 5, whether or not depending on the status of the memory bit to which the LED is connected. The 64 × 1024 fibers originating from 64 × 1024 different fiber bundles destined for one buffer memory are always connected to a positioning element 6 connected, in a manner further illustrated in Fig. 2, to the optically addressable memory 1. The memory circuitry, consisting of 54 × 1024 basic cells, each having a photodetector, is provided in a substrate 1 disposed in a housing 7. Reference numeral 8 indicates a printed circuit board accomodating a plurality of housings 7.

Fig. 2 shows, in more detail, an embodiment of a positioning element 6 ensuring the connection between the optical fibers 3 and the photodetectors of the basic cells.

The positioning element 6 includes a connector portion 10 connected to the optical fibers, said portion having a supporting structure 16 for the optical fibers 3 surrounded by a synthetic plastics cladding 17. Attached to said structure are two pins 18, preferably of steel, fitting in guide bushes 19 provided in a second connector portion 14 having a top surface of a honeycomb structure. In the centre of each cell of the honeycomb there is present the broad top end of a conical optical guide means 20. The narrow lower ends of said conical optical guide means are always situated exactly above the photodetectors of each of the basic cells.

The contact wires 22 and the connecting pins 21 ensure the connection between the memory circuitry in the substrate and the outside world. When the connector portions 10, 14 are relatively positioned and superposed by means of pins 18, 19, always one end of the $64 \times 1024$ optical fibers 1 provided within the plastics cladding 17 is located exactly above the top end of either one of the $64 \times 1024$ guide means 20 so that always one fiber can expose the photodetector of one basic cell.

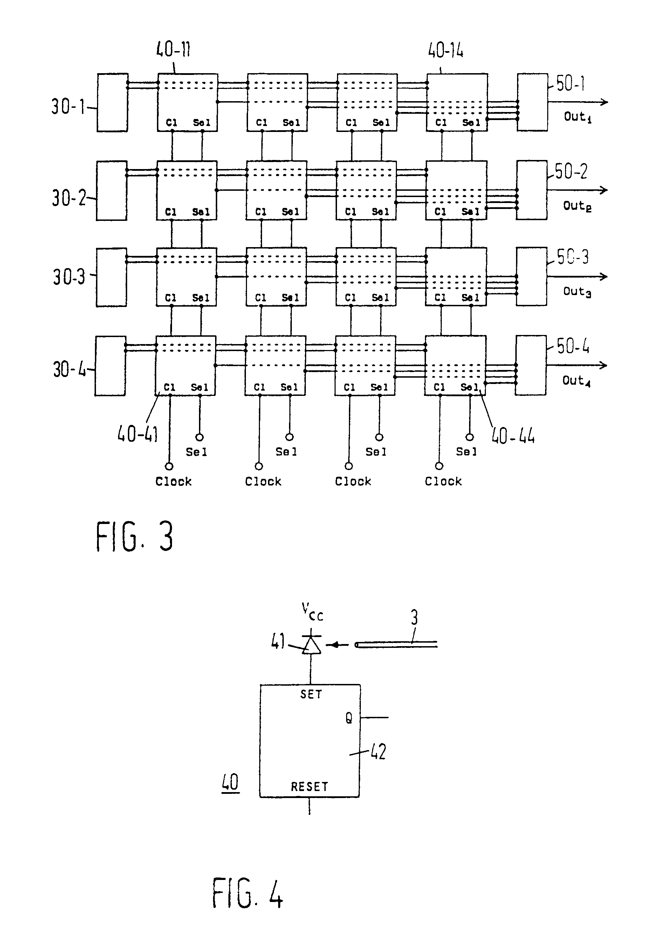

Fig. 3 is a diagrammatic, illustrative view of a buffer memory built up for the sake of simplicity only as a $4 \times 4$ matrix, each element of the matrix being a basic cell 40. Said basic cells are numbered from 40-11....40-44. Reference numerals 30-1.....30-4 indicate reference and supply voltage sources, one being provided for each row of basic elements. The output terminals of all basic cells in one row are connected to respective input terminals of an OR gate 50, there being provided for each row a similar OR gate 50-1....50-4. Likewise, each basic cell is fitted with terminals for supplying control signals, such as a clock signal and a selector signal, which can be applied from suitable known per se sources columnwise to the clock inputs CI and the addressing signal inputs Sel of the basic cells. By a suitable choice of the clock and addressing signals, the memory contents of the basic cells can be read columnwise at the output terminals OUT-1.....OUT 4 of the OR gates 50-1....50-4. Naturally, different known per se control signals can be applied to the basic cells.

Fig. 4 is a block diagram of the architecture of a single basic cell 40. The optical fiber 3 exposes a PIN diode 41 which is connected to the cathode terminal at the set input of a flipflop 42, which flipflop circuitry further has an output terminal Q and a reset input. The anode terminal of diode 41 is connected to the positive supply voltage $V_{cc}$.

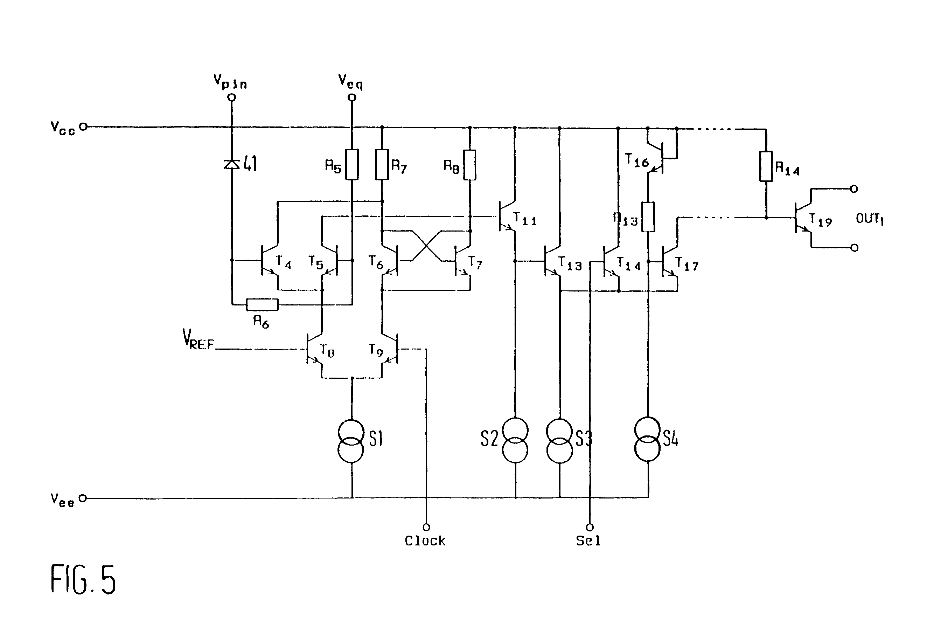

Fig. 5 shows the circuit diagram of the architecture of one of the basic cells 40-1....40-44 incorporated in the matrix of Fig. 4 and the block diagram of which is shown in Fig. 4.

The circuitry is basically built up around a flipflop which, after a rising edge of the clock signal (clock) maintains the state of the PIN diode 41, i.e. exposed or unexposed, as long as the clock signal remains at a high level. The memory contents can be transmitted to the output OUT of the basic cell by means of an addressing signal via a lead Sel. In order to enable high speeds, the entire circuitry is based on current control, in fact on the ECL principle (emitter coupled logic), whereby the saturation of transistors is avoided. By using the slightly n-doped epitaxial layer as "intrinsic" layer when establishing the PIN diode, it is possible to integrate the entire circuitry on one substrate. It is also possible to implement the circuitry in a so-called multilayer architecture in GaAs.

The reference and supply voltage source shown in Fig. 3, e.g. source 30-1, provides the supply voltages $V_{cc}$ and $V_{ee}$ and $V_{pin}$ and an auxiliary voltage $V_{eq}$, as well as a stable reference voltage $V_{ref}$ for the clock detection. The circuitry further comprises transistors $T_4$, $T_9$, $T_{11}$, $T_{13}$, $T_{14}$, $T_{17}$ and $T_{19}$, resistors $R_5$, $R_8$, $R_{13}$, $R_{14}$, four constant current sources $S_1$-$S_4$ and the PIN diode 41. Transistors $T_4$ and $T_5$ and transistors $T_8$ and $T_9$ form two differential amplifier circuits. Transistors $T_6$, $T_7$ together form a bistable circuit and transistors $T_{11}$-$T_{19}$ are connected as emitter followers. The operation of the circuit arrangement is as follows.

The level of the clock signal determines whether the constant current supplied by current source $S_1$ will be distributed through transistor $T_8$ over transistors $T_4$ and $T_5$, or through transistor $T_9$, will flow through either one of transistors $T_6$ or $T_7$ of the bistable circuitry. At a low clock signal level and an unexposed PIN diode 41, slightly more current will flow through transistor $T_5$ than through transistor $T_4$, because the emitter surface of transistor $T_5$ is twice as large as that of transistor $T_4$ (scaling). Upon exposure of the PIN diode 41, being subjected to a substantial reverse bias $V_{pin}$, hole-electron pairs will be generated, which will rapidly drift apart under the influence of the electrical field formed by the potential applied. This current produces a voltage across resistor $R_6$ and hence also between the bases of transistors $T_4$ and $T_5$, which voltage ensures that slightly more current will flow through transistor $T_4$ than through transistor $T_5$. When the clock signal rises, increasingly more current will have to flow through transistor $T_6$ or transistor $T_7$. The base differential voltage initially present (i.e. the collector voltage differential of the preceding stage), in conjunction with the charge on stray capacitances surrounding the transistor, determines how the equilibrium will be adjusted. As soon as the open loop gain exceeds one, a stable adjustment will be reached very quickly, with the voltage sweep being increased from some millivolts in the first stage to 400 millivolts on the collector of transistor $T_7$.

The transistor $T_{11}$ provides a level shift of the out-

put signal of transistor $T_7$. The base of transistor $T_{17}$ is kept at a voltage lying exactly between the two extreme voltages on the base of transistor $T_{13}$. This is attained by having current sources $S_1$ and $S_4$ supply the same current and by imparting to resistor $R_{13}$ exactly half the value of resistor $R_8$. The result of this arrangement is that only when both the voltage on the input Sel and that on the base of transistor $T_{13}$ is low, will the current of current source $S_3$ flow via transistor $T_{17}$ through resistor $R_{14}$. In this manner, it is possible to connect a plurality of basic cells by means of wiring-or to the same output, such as the output $OUT_1$ shown in Fig. 3. Resistor $R_6$ and auxiliary voltage $V_{eq}$ serve to limit undesirable pulses at the clock edge, with transistor $T_{19}$ serving as a buffer and level shift circuitry.

Although, with reference to Figs. 3, 4 and 5, only the operation of a 16 – basic – cell memory system has been described, it will be clear that, without any problem, such a memory system can be designed as an input buffer memory having $64 \times 1024$, or possibly even more basic cells.

## Claims

1. A semiconductor memory system comprising a matrix of electronic basic cells (40) arranged in rows and columns, each of said cells defining a storage location and wherein logic data can be stored bitwise, which data can be read from said storage locations by means of electric addressing signals (Sel), characterized in that each basic cell comprises at least one photodetection means (41), the light-sensitive surfaces of the photodetection means of the basic cells being essentially co-planar, there being provided means (6) for positioning the end faces of a bundle of optical fibers (3) relatively to the matrix of basic cells, while the photodetection means of at least some basic cells can be exposed separately from separate optical fibers for producing a photodetection signal, each basic cell comprising an electronic circuit (42) coupled to said photodetection means, said circuit being adapted to read said photodetection signal under the control of a clock signal and, depending on the signal read, to assume a logic state which persists until a new photodetection signal is read under the control of the clock signal.

2. A semiconductor memory as claimed in claim 1, characterized in that the matrix of basic cells is integrated in a single substrate.

3. A semiconductor memory as claimed in claim 2, characterized in that the substrate is a multilayer substrate.

4. A semiconductor memory as claimed in any of claims 1-3, characterized in that an electronic data processing circuit is coupled to each basic cell in the substrate.

5. A semiconductor memory as claimed in any of claims 1-4, characterized in that the photodetection means of each basic cell is a PIN diode and that the electronic circuit coupled to the diode comprises a flipflop circuit whose output signal represents the logic state.

6. A semiconductor memory as claimed in claim 1, characterized in that the positioning means for the bundle of optical fibers comprise a first connector portion (10) connected to the bundle of optical fibers and at the bottom face of which the end faces of the individual fibers from the bundle are positioned in rows and columns in co-planar relationship, and a second connector portion (14) attached by its bottom face to the layer comprising the photodetection means, while between the top face and the bottom face of the second connector portion there are provided light guide means (20) arranged in rows and columns and adapted to conduct light from the top face to the photodetection means adjacent the bottom face.

7. A semiconductor memory as claimed in claim 6, characterized in that the light guide means have a frusto-conical configuration the larger end face of which is always situated in the top face of the second connector portion.

## Ansprüche

1. Halbleiter-Speichersystem mit einer Matrix aus zu Reihen und Spalten angeordneten elektronischen Basiszellen (40), die jeweils eine Speicherstelle bilden und in denen logische Daten bitweise gespeichert werden können,die sich mittels elektrischer Adressiersignale (Sel) aus den Speicherstellen auslesen lassen, dadurch gekennzeichnet, daß jede der Basiszellen mindestens eine Lichterfassungseinrichtung (41) aufweist und die lichtempfindlichen Oberflächen der Lichterfassungseinrichtungen im wesentlichen koplanar sind, daß Mittel (6) vorgesehen sind, um die Stirnflächen eines Bündels optischer Fasern (3) relativ zu Matrix der Basiszellen zu positionieren, während die Lichterfassungseinrichtung mindestens einiger Basiszellen separat von getrennten optischen Fasern offengelegt werden können, um ein Lichterfassungssignal zu erzeugen, und daß jede Basiszelle (42) eine mit der Lichterfassungseinrichtung gekoppelte elektronische Schaltung aufweist, die das Lichterfassungssignal unter Steuerung durch ein Taktsignal lesen und abhängig vom gelesenen Signal einen logischen Zustand annehmen kann, der erhalten bleibt, bis ein neues Lichterfassungssignal unter Steuerung durch das Taktsignal gelesen wird.

2. Halbleiterspeicher nach Anspruch 1, dadurch gekennzeichnet, daß die Basiszellenmatrix auf einem einzigen Substrat integriert ist.

3. Halbleiterspeicher nach Anspruch 2, dadurch gekennzeichnet, daß es sich bei dem Substrat um ein mehrlagiges Substrat handelt.

4. Halbleiterspeicher nach einem der Ansprüche 1-3, dadurch gekennzeichnet, daß mit jeder Basiszelle auf dem Substrat eine elektronische Datenverarbeitungsschaltung gekoppelt ist.

5. Halbleiterspeicher nach einem der Ansprüche 1-4, dadurch gekennzeichnet, daß die Lichterfassungseinrichtung jeder Basiszelle eine PIN-Diode ist und die mit der Diode gekoppelte elektronische Schaltung eine Flipflop-Schaltung aufweist, deren Ausgangssignal den logischen Zustand darstellt.

6. Halbleiterspeicher nach Anspruch 1, dadurch gekennzeichnet, daß die Positioniereinrichtung für das Bündel optischer Fasern einen ersten Verbinderteil (10), der an das Bündel optischer Fasern angeschlossen ist, und an dessen Unterseite die Stirnflächen der einzelnen Fasern des Bündels in Reihen und Spalten komplanar angeordnet sind, und einen zweiten Verbinderteil aufweist, der mit seiner Unterseite an der die Lichterfassungseinrichtung aufweisenden Schicht angebracht ist, während zwischen der Ober- und der Unterseite des zweiten Verbinderteils Lichtleiteinrichtungen (20) vorgesehen sind, die zu Reihen und Spalten angeordnet sind und Licht von der Oberseite zur Lichterfassungseinrichtung an der Unterseite leiten können.

7. Halbleiterspeicher nach Anspruch 6, dadurch gekennzeichnet, daß die Lichtleiteinrichtungen eine kegelstumpfförmige Gestalt haben, deren größere Stirnfläche immer in der Oberseite des zweiten Verbinderteils liegt.

## Revendications

1. Système de mémoire à semi-conducteur comprenant une matrice de cellules électroniques de base (40), agencées en rangées et colonnes, chacune desdites cellules définissant un emplacement de stockage, et dans lesquelles des données logiques peuvent être stockées sous la forme d'unités d'informations, lesquelles données peuvent être lues à partir desdits emplacements de stockage au moyen de signaux électriques d'adressage (Sel), caractérisé en ce que chaque cellule de base comprend au moins un moyen de photodétection (41), les surfaces sensibles à la lumière du moyen de photodétection des cellules de base étant essentiellement coplanaires, des moyens (6) étant prévus pour positionner les faces d'extrémité d'un faisceau de fibres optiques (3) relativement à la matrice de cellules de base, tandis que les moyens de photodétection d'au moins certaines cellules de base peuvent être exposés séparément à partir de fibres optiques séparées pour produire un signal de photodétection, chaque cellule de base comprenant un circuit électronique (42) couplé audit moyen de photodétection, ledit circuit étant adapté pour lire ledit signal de photodétection sous la commande d'un signal d'horloge et, selon le signal lu, pour prendre un état logique qui persiste jusqu'à ce qu'un nouveau signal de photodétection soit lu sous la commande du signal d'horloge.

2. Mémoire à semi-conducteur selon la revendication 1, caractérisée en ce que la matrice de cellules de base est intégrée dans un substrat unique.

3. Mémoire à semi-conducteur selon la revendication 2, caractérisée en ce que le substrat est un substrat à plusieurs couches.

4. Mémoire à semi-conducteur selon l'une quelconque des revendications 1 à 3, caractérisée en ce qu'un circuit de traitement électronique de données est couplé à chaque cellule de base dans le substrat.

5. Mémoire à semi-conducteur selon l'une quelconque des revendications 1 à 4, caractérisée en ce que le moyen de photodétection de chaque cellule de base est une diode PIN et en ce que le circuit électronique couplé à la diode comprend un circuit flip-flop dont le signal de sortie représente l'état logique.

6. Mémoire à semi-conducteur selon la revendication 1, caractérisée en ce que les moyens de positionnement pour le faisceau de fibres optiques comprennent une première portion de connecteur (10) reliée au faisceau de fibres optiques et à la face arrière de laquelle les faces d'extrémité des fibres individuelles du faisceau sont positionnées en rangées et colonnes en relation coplanaire, et une seconde portion de connecteur (14) fixée par sa face arrière à la couche comprenant le moyen de photodétection, tandis que, entre la face avant et la face arrière de la seconde portion de connecteur, sont prévus des moyens de guidage de la lumière (20) agencés en rangées et colonnes et adaptés pour conduire la lumière de la face avant au moyen de photodétection adjacent à la face arrière.

7. Mémoire à semi-conducteur selon la revendication 6, caractérisée en ce que les moyens de guidage de la lumière présentent une configuration tronconique dont la face d'extrémité la plus grande est toujours située dans la face avant de la seconde portion de connecteur.

FIG. 1

FIG. 2

FIG. 3

FIG. 4

FIG. 5

EP 0 270 149 B1